(19) Europäisches Patentamt
European Patent Office
Office européen des brevets

(11) **EP 1 754 311 B1**

(12) **FASCICULE DE BREVET EUROPEEN**

(45) Date de publication et mention
de la délivrance du brevet:
**19.12.2007 Bulletin 2007/51**

(51) Int Cl.:
*H03M 13/29* (2006.01)   *H04L 1/00* (2006.01)
*H03M 13/33* (2006.01)

(21) Numéro de dépôt: **05775230.5**

(22) Date de dépôt: **01.06.2005**

(86) Numéro de dépôt international:
**PCT/FR2005/001350**

(87) Numéro de publication internationale:
**WO 2006/005835 (19.01.2006 Gazette 2006/03)**

(54) **SYSTEME DE COMPENSATION DE DEPHASAGE POUR TURBO DECODEUR**

SYSTEM ZUR KOMPENSATION DER PHASENVERSCHIEBUNG EINES TURBODEKODIERERS

SYSTEM FOR COMPENSATING TURBODECODER PHASE SHIFT

(84) Etats contractants désignés:
**AT BE BG CH CY CZ DE DK EE ES FI FR GB GR HU IE IS IT LI LT LU MC NL PL PT RO SE SI SK TR**

(30) Priorité: **10.06.2004 FR 0406290**

(43) Date de publication de la demande:
**21.02.2007 Bulletin 2007/08**

(73) Titulaires:
• **Centre National de la Recherche Scientifique (CNRS) Etablissement Public à Caractère Scientifique et Technologique**
**75016 Paris (FR)**
• **Institut National Polytechnique de Grenoble**
**38000 Grénoble Cédex (FR)**

(72) Inventeurs:
• **GELLER, Benoît**
**F-75005 PARIS (FR)**
• **BARBOT, Jean-Pierre**
**F-92130 ISSY LES MOULINEAUX (FR)**
• **BROSSIER, Jean-Marc**
**38400 SAINT MARTIN D'HERES (FR)**
• **VANSTRACEELE, Christophe**
**F-25000 Besancon (FR)**

(74) Mandataire: **Domenego, Bertrand et al**
**Cabinet Lavoix**
**2, place d'Estienne d'Orves**
**75441 Paris Cedex 09 (FR)**

(56) Documents cités:
**US-A1- 2002 097 814**

• LOTTICI V ET AL: "EMBEDDING CARRIER PHASE RECOVERY INTO ITERATIVE DECODING OF TURBO-CODED LINEAR MODULATIONS" IEEE TRANSACTIONS ON COMMUNICATIONS, IEEE INC. NEW YORK, US, vol. 52, no. 4, avril 2004 (2004-04), pages 661-669, XP001197594 ISSN: 0090-6778
• CIONI S ET AL: "Turbo embedded estimation with imperfect phase/frequency recovery" ICC 2003. 2003 IEEE INTERNATIONAL CONFERENCE ON COMMUNICATIONS. ANCHORAGE, AK, MAY 11 - 15, 2003, vol. VOL. 1 OF 5, 11 mai 2003 (2003-05-11), pages 2385-2389, XP010642874 ISBN: 0-7803-7802-4
• BARRATT K A ET AL: "Performance bounds for double sampling ML-DD feedback timing synchronisers in turbo code systems" ELECTRONICS LETTERS, IEE STEVENAGE, GB, vol. 37, no. 7, 29 mars 2001 (2001-03-29), pages 442-443, XP006016410 ISSN: 0013-5194
• LANGLAIS C ET AL: "Synchronisation in the carrier recovery of a satellite link using turbo-codes with the help of tentative decisions" IEE COLLOQUIUM. TURBO CODES IN DIGITAL BROADCASTING - COULD IT BE DOUBLE CAPACITY, 22 novembre 1999 (1999-11-22), pages 5-1, XP002178507
• NISSILA M J ET AL: "An EM approach to carrier phase recovery in AWGN channel" ICC 2001. 2001 IEEE INTERNATIONAL CONFERENCE ON COMMUNICATIONS. CONFERENCE RECORD. HELSINKY, FINLAND, JUNE 11 - 14, 2001, IEEE INTERNATIONAL CONFERENCE ON COMMUNICATIONS, NEW YORK, NY : IEEE, US, vol. VOL. 1 OF 10, 11 juin 2001 (2001-06-11), pages 2199-2203, XP010553707 ISBN: 0-7803-7097-1

- **OH W ET AL: "JOINT DECODING AND CARRIER PHASE RECOVERY ALGORITHM FOR TURBO CODES" IEEE COMMUNICATIONS LETTERS, IEEE SERVICE CENTER, PISCATAWAY,US, US, vol. 5, no. 9, septembre 2001 (2001-09), pages 375-377, XP001107973 ISSN: 1089-7798 cité dans la demande**

**Description**

La présente invention concerne un système et un procédé de compensation de déphasage pour un turbo décodeur à blocs.

A ce jour, les turbo codes sont considérés comme les schémas de codage les plus efficaces pour les corrections d'erreurs sans voie de retour (Forward Error Correction - FEC).

Le principe du turbo code a été présenté pour la première fois à la conférence ICC'93 de Genève par C. Berrou, A. Glavieux et Thitimajshima. Ce document présente un décodage itératif de deux codes convolutifs concaténés en parallèle à travers un entrelaceur non uniforme. Le décodage est effectué par un décodeur SISO (Soft Input / Soft Output : Entrée souple / sortie souple) basé sur un algorithme MAP (Maximum a Posteriori).

En 1993, EP 0 654 910, délivré à France Télécom, incorporé par référence, a décrit un turbo code basé sur des codes blocs. Ce turbo code utilise le décodage itératif de deux codes BCH (code Bosc-Hacquengheim-Chaudhuri) concaténés en série à travers un entrelaceur uniforme. Le décodage utilise un nouveau décodeur SISO adapté aux codes blocs. Cet algorithme de décodage est connu sous le nom d'algorithme de Pyndiah.

Les turbo codes présentent des performances remarquables proches de la limite théorique de Shannon.

Ils requièrent cependant une synchronisation parfaite au niveau de la réception, ce qui n'est pas réaliste dans le cas des signaux ayant un faible rapport signal / bruit, domaine d'utilisation privilégiée de ces algorithmes de décodage.

En effet, il a été constaté par Oh et Cheun (« Joint Decoding and Carrier Phase Recovery Algorithm for Turbo Codes », Wangrok Oh et Kyungwhoon Cheun, IEEE Communications Letters, vol. 5, N° 9, septembre 2001, p. 375) qu'une erreur de phase a pour conséquence une dégradation du taux d'erreurs sur les bits (Bit Error Rate - BER).

Oh et Cheung décrivent également, dans ce document, un dispositif à boucle d'asservissement adaptatif permettant, au niveau du décodeur, de compenser le décalage de phase. Cette compensation est calculée à partir de la puissance estimée des valeurs extrinsèques du décodeur, ou de la puissance estimée des ratios de vraisemblance logarithmique, en sortie du deuxième décodeur.

Bien que Oh et Cheung prennent comme exemple un turbo décodage convolutif, le problème existe également pour les turbo codes à blocs et en particulier pour le décodeur de Pyndiah.

Le but de l'invention est donc l'obtention d'un turbo décodeur à blocs qui soit résistant au déphasage.

Il est également à noter que la publication de Lottici F et Luise M, "Embedding Carrier Phase Recovery Into Iterative Decoding of Turbo-Coded Linear Modulations", IEEE transactions on communications, vol. 52, no. 4, avril 2004, pages 661-669, décrit une méthode de recouvrement de phase utilisant les sorties douces d' une turbo décodeur. Le calcul du déphasage utilise la moyenne sur un bloc de données des rapports de vraisemblance (LLR) associées aux données systématiques. D1 indique que la contribution des symboles à faible fiabilité est négligeable.

En outre, le document US2002/0097814 A (Eidson et al., 25 Juillet 2002), décrit une méthode de recouvrement de phase utilisant la fiabilité des symboles estimés par un turbo décodeur à concaténation sérielle. Un déphasage est estimé en calculant la moyenne des déphasages entre les symboles reçus et les symboles estimés, pondérée par la fiabilité estimée. L'estimation des symboles est dérivée de l'information extrinsèque du décodeur SISO interne du turbo décodeur sériel.

L'objet de l'invention est donc un système récepteur à turbo code d'un signal émis par un système émetteur, ce signal étant soumis par l'émetteur à un turbo codage et à une modulation numérique, caractérisé en ce qu'il comporte :

- un démappeur souple apte à recevoir le signal modulé et à le convertir en une suite de mots, chaque mots étant composés de n bits, et chaque bit étant connecté à une valeur de fiabilité de la valeur du bit, dont la sortie est connectée à

- un turbo décodeur apte à générer une liste de mots correspondant aux données numériques décodées ainsi qu'un vecteur de fiabilité ($LLR_{out}$) du résultat associé à chaque mot et comportant la valeur de fiabilité de chaque bit du mot, ce turbo décodeur étant un turbo décodeur à blocs comportant un décodeur SISO itératif tel que l'entrée ($R_m$) du décodeur SISO soit égale au vecteur (R) des valeurs de fiabilité en sortie du démappeur souple sommé par le produit d'un coefficient ($\alpha$) et de la différence entre la sortie ($R'_m$) du décodeur SISO à l'itération précédente et dudit vecteur (R) des valeurs de fiabilité en sortie du démappeur souple,

et comportant également une boucle d'asservissement adaptative comportant

- un générateur de mesure dont l'entrée est connectée à la sortie du turbo décodeur afin de recevoir le vecteur de fiabilité ($LLR_{out}$) du résultat et apte à transformer ce vecteur en une mesure de fiabilité (M(I)), égale à la moyenne des plus petites valeurs de fiabilité des bits du mot, transmise à

- un estimateur de déphasage apte à calculer l'écart entre la phase correspondant à la mesure de fiabilité (M(I)) reçue et celle correspondant au maximum de cette mesure, dont la sortie est connectée à

- un compensateur de phase positionné en amont du démappeur souple et apte à corriger le signal entrant de la

valeur de phase ($\varphi$) calculée par l'estimateur.

Suivant des modes particuliers de réalisation, le système comporte une ou plusieurs des caractéristiques suivantes :

- la mesure de fiabilité (M(I)) est égale à la moyenne des valeurs de fiabilité sensiblement inférieures à une valeur déterminée,
- l'estimateur de déphasage, estime le déphasage en supposant que la mesure de fiabilité (M(I)) est une fonction parabolique du déphasage,
- l'estimateur de déphasage, estime le déphasage comme la somme de l'estimation ($\varphi_0$) pour le mot de code précédent et d'une constante ($\Delta\varphi$) pondérée, un intervalle de calcul étant défini comme ayant pour centre l'estimation ($\varphi_0$) pour le mot de code précédent et pour demi largeur la constante ($\Delta\varphi$), et la pondération de la constante étant le ratio entre la différence entre les valeurs de fiabilité (M($\varphi_1$), M($\varphi_2$)) aux extrémités de l'intervalle de calcul et la quadruple valeur de fiabilité M($\varphi_0$) à l'estimation précédente diminuée du double de la somme des valeurs de fiabilité (M($\varphi_1$), M($\varphi_2$)) aux extrémités de l'intervalle de calcul,
- la modulation est une modulation QAM,
- un désembrouilleur ou un désentrelaceur est intercalé entre le démappeur souple et le turbo décodeur,
- le système de transmission d'un flux de données numériques binaires comporte un système récepteur,
- un embrouilleur, ou un entrelaceur, est intercalé entre le codeur canal et le modulateur et un désembrouilleur, respectivement un désentrelaceur, est intercalé entre le démappeur souple et le turbodécodeur,

L'invention a également pour objet un procédé de réception d'un signal numérique turbo codé et modulé, comportant les étapes suivantes :

a) réception d'un élément de la constellation de la modulation,
b) démappage souple de cet élément pour obtenir un mot de n bits, chaque bit étant associé à une valeur de fiabilité de la valeur de ce bit,
c) turbo décodage de ce mot de n bits fournissant un autre mot correspondant aux données numériques décodées ainsi qu'un vecteur de fiabilité de ce résultat comportant la valeur de fiabilité de chaque bit du mot, ce turbo décodage étant un turbo décodage à blocs comportant un décodage SISO itératif tel que l'entrée du décodage SISO soit égale au vecteur des valeurs de fiabilité en sortie du démappage souple sommé par le produit d'un coefficient et de la différence entre la sortie du décodage SISO à l'itération précédente et dudit vecteur des valeurs de fiabilité en sortie du démappage souple.
d) calcul d'une mesure de fiabilité égale à la moyenne des plus petites valeurs de fiabilité des bits du mot,
e) estimation du déphasage par calcul de l'écart entre la phase correspondant à la mesure de fiabilité reçue et celle correspondant au maximum de cette mesure,
f) compensation par le déphasage estimé en réception du signal modulé.

- à l'initialisation, l'estimation de déphasage parcourt l'espace des phases selon un pas égal à la moitié de la largeur du lobe de la mesure de fiabilité.
- pour chaque mot reçu, les étapes b) à f) sont itérées en utilisant comme estimation de déphasage,
- l'estimation de déphasage du mot précédent, puis
- l'estimation de déphasage du mot précédent moins une valeur prédéterminée, puis
- l'estimation de déphasage du mot précédent plus une valeur prédéterminée, puis,

l'estimation du déphasage ayant été calculée comme la somme de l'estimation ($\varphi_0$) pour le mot de code précédent et d'une constante ($\Delta\varphi$) pondérée, un intervalle de calcul étant défini comme ayant pour centre l'estimation ($\varphi_0$) pour le mot de code précédent et pour demi largeur la constante ($\Delta\varphi$), et la pondération de la constante étant le ratio entre la différence entre les valeurs de fiabilité (M($\varphi_1$), M($\varphi_2$)) aux extrémités de l'intervalle de calcul et la quadruple valeur de fiabilité M($\varphi_0$) à l'estimation précédente diminuée du double de la somme des valeurs de fiabilité (M($\varphi_1$), M($\varphi_2$)) aux extrémités de l'intervalle de calcul, les étapes b) et c) sont effectuées pour obtenir le mot correspondant aux données numériques décodées.

L'invention sera mieux comprise à la lumière de la description qui va suivre, donnée uniquement à titre d'exemple, et faite en référence aux dessins annexés et dans lesquels :

- la figure 1 est la représentation d'une constellation d'une modulation QAM,
- la figure 2 est la représentation de l'évolution du BER en fonction d'une erreur de phase pour un signal codé BCH (32, 26, 4)$^2$ sur 1024-QAM (Eb/No = 19dB) ;

- la figure 3 est un schéma synoptique d'une implémentation de l'invention ;
- la figure 4 est un schéma du turbo décodeur de Pyndiah selon l'art antérieur ;
- la figure 5 est un schéma du turbo décodeur selon un mode de réalisation de l'invention ;
- la figure 6 est une représentation de la distribution de probabilité des valeurs absolues des fiabilités avec 4 demi-itérations pour un signal codé BCH $(32,26,4)^2$ sur 1024-QAM (Eb/No = 21dB), chaque courbe correspondant à une erreur de phase différente ;
- la figure 7 est une moyenne de M pour 20 mots de code en fonction de l'erreur de phase ;
- la figure 8 est un schéma synoptique de fonctionnement d'un mode de réalisation de l'invention ;
- la figure 9 est l'évolution de M en fonction de l'erreur de phase avec et sans entrelaceur ;
- la figure 10 est un schéma d'un système de codage/décodage selon un autre mode de réalisation de l'invention.

L'objet d'un codage canal est, en règle générale, d'introduire des éléments de redondance qui permettent, en réception, et malgré le bruit de transmission, de reconstruire l'information transmise. Dans l'exemple décrit, le codage canal est un code produit construit à partir de codes BCH de Hamming étendus par un bit de parité, noté BCH$(32, 26, 4)^2$.

Une fois le codage de redondance effectué, les données sont modulées avant transmission.

Actuellement une technique de modulation de signal largement utilisée est la Modulation Quadratique en Amplitude (Quadrature Amplitude Modulation - QAM).

La description qui suit s'appuie sur ce type de modulation uniquement à titre d'exemple. L'homme du métier saura, sans difficulté particulière, transposer le mode de réalisation décrit à une autre modulation telle qu'une modulation par saut de phase (phase shift keying - PSK) ou par continuité de plase (Minimum Shift Keying - MSK).

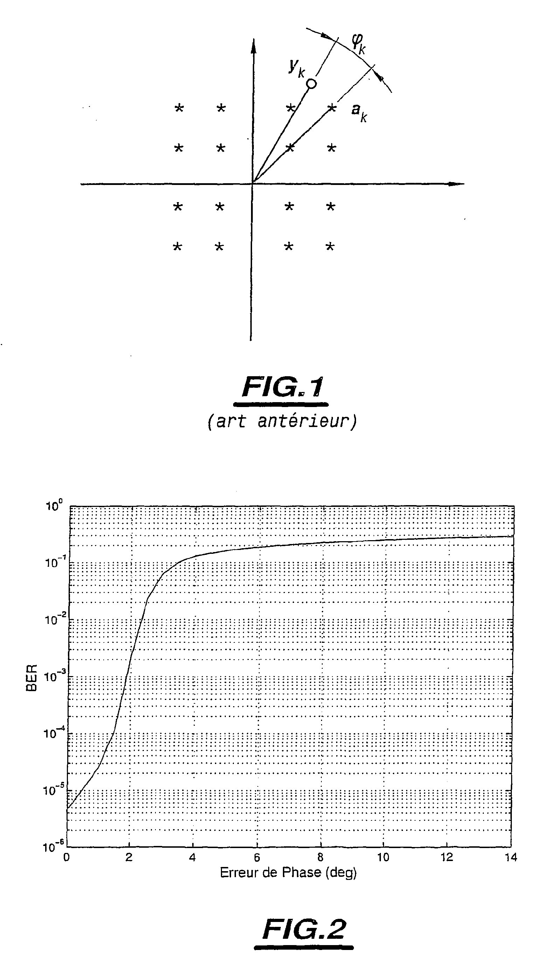

La modulation QAM est une combinaison d'une modulation en amplitude et en décalage de phase. Cette modulation consiste à répartir le flux de données, qui se présente sous la forme d'un flux de bits, en blocs de n bits. Il y a ainsi $2^n$ combinaisons possibles définissant une modulation $2^n$-QAM. Les $2^n$ mots sont répartis sur l'ensemble des combinaisons amplitude / décalage de phase définies pour la modulation. Cette répartition est souvent appelée la constellation QAM. Il est ainsi habituel de représenter cette répartition dans le plan complexe, figure 1, sur lequel chaque mot $a_k$ est représenté par un point dont la distance à l'origine représente l'amplitude et l'angle par rapport à l'axe des x le décalage de phase.

A la réception, en considérant que l'estimation des instants d'échantillonnage est parfaite et qu'il n'y a qu'une erreur sur la phase de la porteuse, cette erreur correspond alors à une rotation de la constellation QAM d'un angle correspondant à ce déphasage. On conçoit aisément qu'une telle rotation peut générer une erreur sur la valeur du symbole finalement détecté.

Cette erreur de phase provoque une augmentation du taux d'erreur binaire (BER), figure 2. On constate ainsi qu'une erreur de deux degrés multiplie par cent ce taux d'erreur.

Si $y_k$ est le symbole reçu et $a_k$ le symbole QAM émis,

$$y_\kappa = a_\kappa \, e^{j\,\varphi}{}_\kappa + n_\kappa \qquad\qquad (1)$$

où $n_\kappa$ est un bruit gaussien et $\varphi_\kappa$ la rotation de phase induite par l'erreur sur la phase de la porteuse. $\varphi_\kappa$ est considérée comme constante pendant le temps de transmission du symbole $a_k$. Cette hypothèse est pratiquement toujours réalisée dans la mesure où la gigue du signal peut être considérée comme une perturbation basse fréquence.

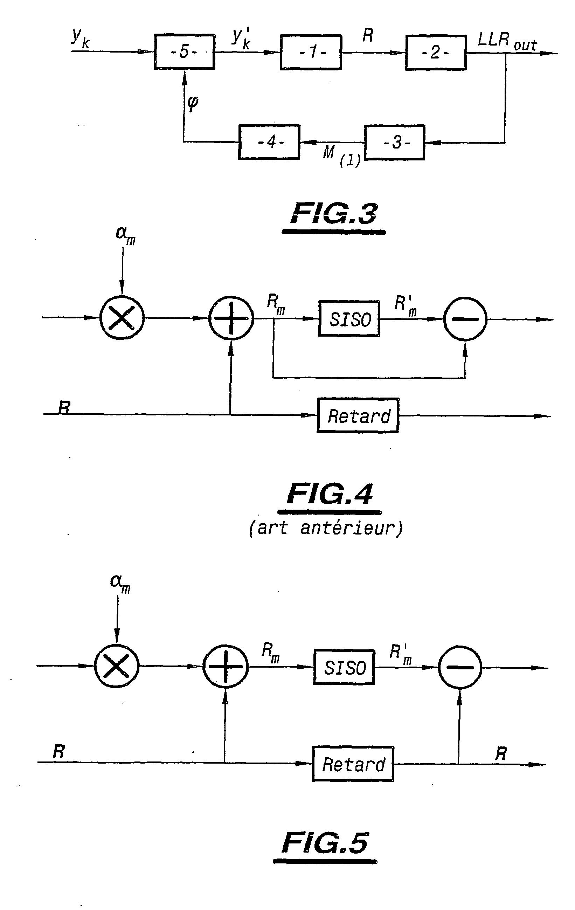

Le système, figure 3, récupère donc les symboles $y_\kappa$ en entrée d'un démappeur souple 1.

Le démappeur souple 1 fournit un mot par constellation ainsi qu'une valeur correspondant à la fiabilité du résultat. Autrement dit, le démappeur 1 effectue l'opération de conversion d'un couple (amplitude, décalage de phase) en un mot de n bits.

Cependant, du fait du bruit et de la rotation de phase, $y_\kappa$ se trouve en fait à une certaine distance du symbole le plus proche.

Soit $\Lambda(e_j)$ le ratio de vraisemblance logarithmique, ou log-vraisemblance, du bit $e_j$ (Log-Likelyhood Ratio - LLR) défini comme

$$\Lambda(e_j) = Ln\left[\frac{P\left(\dfrac{e_j = +1}{R}\right)}{P\left(\dfrac{e_j = -1}{R}\right)}\right] \qquad\qquad (2)$$

dans lequel $P\{ej = \varepsilon / R\}, \varepsilon = \pm 1$, désigne la probabilité conditionnelle que le bit $e_j$ corresponde à la valeur mappée $\varepsilon$, compte tenu du mot de code reçu R, et Ln désigne le logarithme népérien.

alors $\Lambda(e_j)$ est positif si la probabilité que $e_j$ soit égale à 1 est supérieure à celle que $e_j$ soit égal à 0, et $\Lambda(e_j)$ est négatif dans le cas inverse.

La log-vraisemblance est classiquement utilisée comme valeur de fiabilité du résultat.

Le démappeur souple 1 fournit ainsi en sortie le vecteur R des LLR de chaque bit du mot démodulé.

Ce vecteur R est fourni en entrée du turbo décodeur 2. Celui-ci, en utilisant la redondance créée lors du codage canal, génère en sortie d'une part le mot décodé ainsi qu'une $LLR_{out}$ d'estimation de la fiabilité du résultat trouvé.

Afin de créer une boucle d'asservissement adaptative sur la correction du déphasage, les $LLR_{out}$ générés par le turbo décodeur 2 sont introduits comme paramètres d'entrée d'un générateur de mesure 3 qui transforme l'ensemble des $LLR_{out}$ en une mesure $M^{(l)}$ représentative de la fiabilité du mot 1 décodé.

Comme expliqué ci-dessous, $M^{(l)}$ est une fonction dépendant de deux paramètres : le mot à décoder et le décalage de phase. Sa notation complète est donc $M(I, \varphi)$. Cependant, afin de simplifier la notation et de mettre en évidence le paramètre pertinent, la notation $M^{(l)}$ est utilisée quand c'est la variation de M par rapport aux mots qui est considérée et $M(\varphi)$ est utilisée quand c'est la variation de M par rapport au déphasage qui est étudiée.

Cette mesure est alors utilisée par l'estimateur de déphasage 4 pour calculer un déphasage estimé $\varphi$ qui est soustrait en 5 au signal d'entrée.

Le turbo décodeur 2 utilise un algorithme itératif de type Pyndiah.

Le turbo décodeur de Pyndiah, figure 4, utilise un décodage SISO (Soft In / Soft Out ; entrée souple / sortie souple).

A titre de rappel, un algorithme SISO fait partie des classes d'algorithme qui utilisent en entrée des probabilités sur les bits (ou « soft values ») pour générer d'autres probabilités sur les bits de sortie décodés. Ils se différentient des algorithmes du type « Démodulateur a Entrée Rigide » (Hard Input (HI) Decoder) qui prennent des décisions dures sur la donnée reçue, c'est-à-dire qu'ils fixent la valeur à 0 ou 1 en fonction des critères du décodage.

En appelant R(i) l'entrée d'un algorithme SISO et R'(i) sa sortie à la demi itération i, et, comme indiqué précédemment, R le vecteur des LLR en sortie du démappeur souple (et donc R(1)=R), l'entrée pour la prochaine boucle SISO i+1 est définie par

$$R(i+1) = R + \alpha(i)(R'(i) - R(i)) \qquad (3)$$

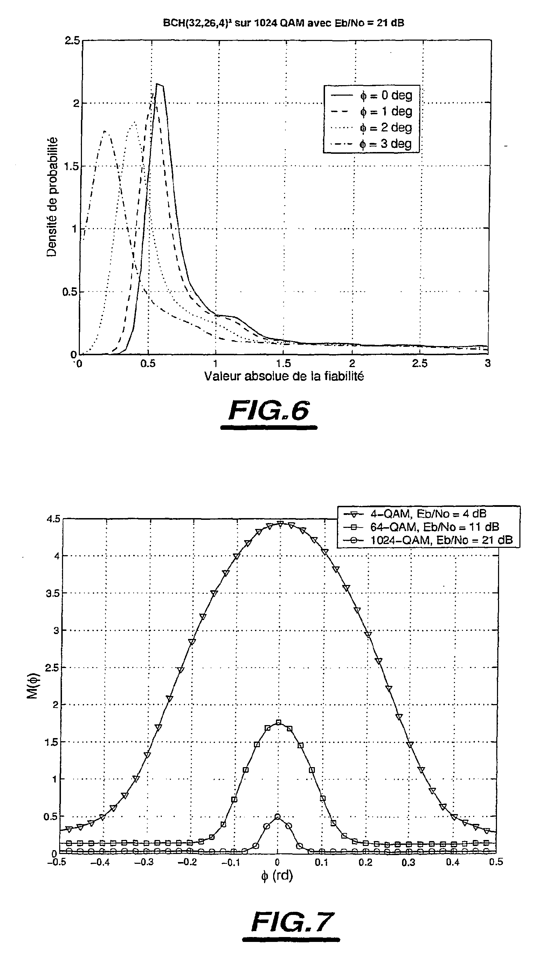

Le système peut également modifier cet algorithme, figure 5, de telle sorte que

$$R(i+1) = R + \alpha(i)(R'(i) - R) \qquad (4)$$

Ainsi, l'entrée du décodeur SISO est égale au vecteur R des valeurs de fiabilité en sortie du démappeur souple sommé par le produit d'un coefficient $\alpha$ et de la différence entre la sortie du décodeur SISO à l'itération précédente R'(i) et dudit vecteur R des valeurs de fiabilité en sortie du démappeur souple. Dans cette équation, $\alpha(i)$ est un coefficient de convergence déterminé expérimentalement.

L'avantage de cette implémentation est de lisser l'évolution de la mesure $M^{(l)}$ et donc, comme expliqué ci-après, de permettre un calcul plus aisé de l'estimation du déphasage. Ce lissage est dû au fait que toute l'information apportée par les décodages précédents se propage dans les décodages suivants.

Le décalage en phase de la porteuse, tel que modélisé par l'équation (1), induit une augmentation de la distance euclidienne par rapport au mot émis, et donc une diminution des valeurs de fiabilités en sortie du turbo décodeur, et donc un risque d'erreur accru.

Or, la demanderesse a constaté, figure 6, que les valeurs de fiabilité les plus faibles sont les plus sensibles à ce phénomène.

En effet, pour les valeurs de fiabilité importantes, l'ordre de grandeur reste sensiblement constant que l'on soit synchronisé ou non : certains bits convergeront toujours malgré une mauvaise synchronisation.

Au contraire, les valeurs de fiabilité les plus faibles tendent vers zéro quand le décalage de phase augmente. Elles sont donc plus sensibles à ce décalage et apportent donc une information plus pertinente pour la correction de celui-ci. Ainsi, on constate sur la figure 6 que la distribution des valeurs de fiabilité inférieures à 1,5 dépend très fortement de cette erreur de phase.

La mesure de cette distribution, notée $M^{(l)}$, représente donc la moyenne des plus petites valeurs de fiabilités à la fin du décodage du $l^{ième}$ mot de code reçu :

$$M(l) = \frac{1}{n}\sum_{k=1}^{n}\left|LLRM_k^{(l)}\right| \qquad (5)$$

où n est un entier plus petit que la longueur du code et LLRM$^{(1)}$ est le vecteur contenant les n plus petites valeurs de fiabilité du mot considéré.

Le nombre n est choisi par l'homme du métier pour assurer un compromis entre un nombre suffisant de termes dans la moyenne et la perturbation apportée par les grandes valeurs de fiabilité.

Une méthode équivalente de choix consiste à se fixer une valeur maximale au-delà de laquelle une valeur de fiabilité n'est pas comptée dans la moyenne. Cela permet de s'affranchir du tri des valeurs de fiabilité tout en conservant le même type de résultat.

Comme indiqué, cette mesure M$^{(l)}$ est introduite comme paramètre d'entrée dans l'estimateur de phase.

Or l'étude de l'influence du déphasage $\varphi$ sur la mesure M$^{(l)}$ montre, figure 7, que M$^{(l)}$ est à son maximum pour un déphasage nul.

En supposant que les conditions sont telles que l'estimateur est dans sa zone de convergence, la valeur maximale de M$^{(l)}$ peut être atteinte avec un algorithme de gradient stochastique.

Dans ce cas, l'algorithme général de recherche du déphasage de la porteuse s'écrit

$$\hat{\varphi} = \hat{\varphi}_{i-1} + \mu(M(\hat{\varphi}_{i-1}, y_1,..., y_k) - M(\hat{\varphi}_{i-2}, y_1,..., y_k))\left[sign(\hat{\varphi}_{i-2} - \hat{\varphi}_{i-1})\right] \quad (6)$$

où, classiquement, la valeur du pas $\mu$ est choisie de façon à réaliser un compromis entre l'erreur quadratique moyenne et la vitesse de convergence.

La valeur choisie pour initialiser l'algorithme à chaque nouveau mot de code est la valeur qui est estimée pour le mot de code précédent.

Cet algorithme a cependant l'inconvénient de demander un nombre d'estimations de M$^{(l)}$ relativement important.

Une variante de l'algorithme plus légère en temps de calcul peut être obtenue en modélisant l'évolution de M$^{(l)}$ par une simple parabole dans son cône de convergence.

Dans ce cas, trois évaluations sont suffisantes pour obtenir $\hat{\varphi}$.

En considérant $\varphi_o$ et une constante $\Delta\varphi$, et en définissant $\varphi_1 = \varphi_0 - \Delta\varphi$ *et* $\varphi_2 = \varphi_0 + \Delta\varphi$ le maximum est alors donné par :

$$\hat{\varphi} = \varphi_0 + \Delta\varphi \frac{M(\varphi_2) - M(\varphi_1)}{4M(\varphi_0) - 2M(\varphi_2) - 2M(\varphi_1)} \qquad (7)$$

En prenant pour $\varphi_0$ la valeur de l'estimation pour le mot de code précédent, l'estimation de déphasage est donc la somme de l'estimation $\varphi_0$ pour le mot de code précédent et d'une constante $\Delta\varphi$, cette constante étant pondérée par le ratio entre la différence entre les valeurs de fiabilité (M($\varphi_1$), M($\varphi_2$)) aux extrémités de l'intervalle de calcul et la quadruple valeur de fiabilité M($\varphi_0$) à l'estimation précédente diminuée de la double valeurs des fiabilité aux extrémités de l'intervalle de calcul.

Cette méthode permet une économie importante en termes d'évaluation du critère.

Cependant, la modélisation en parabole de l'évolution de M$^{(l)}$ n'est qu'une approximation et n'est donc pas totalement indépendant de $\Delta\varphi$. Il existe ainsi une valeur optimale de ce paramètre pour laquelle l'estimation sera la meilleure possible.

La demanderesse a constaté que dans ses conditions expérimentales, une estimation optimale est obtenue pour $\Delta\varphi$ égal à 20% de la largeur du lobe de la courbe M($\varphi$).

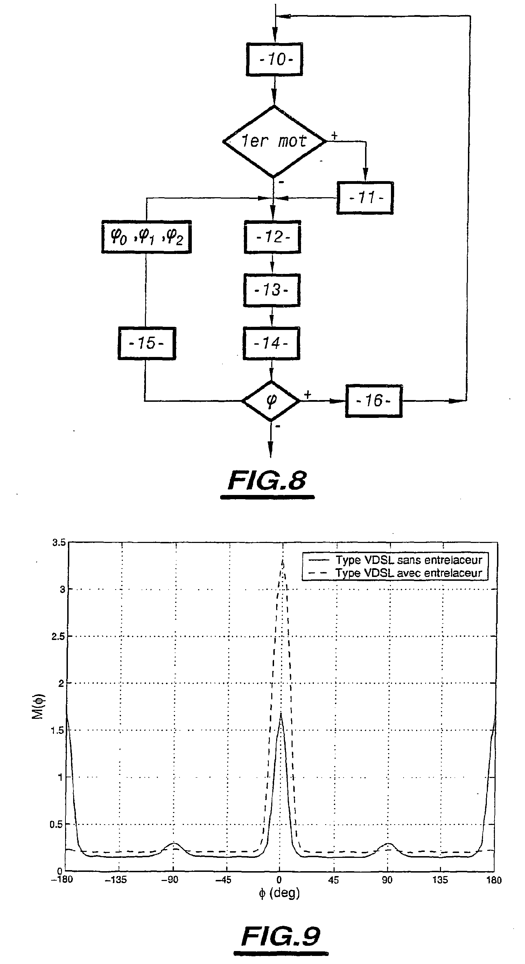

Le système ainsi décrit fonctionne de la manière suivante, figure 8.

Le système reçoit un mot à l'étape 10.

A l'initialisation, c'est-à-dire au premier mot reçu, le système parcourt en 11 l'intervalle [-$\pi$, +$\pi$] de l'espace de déphasage, avec un pas correspondant à la moitié de la largeur du lobe, celle-ci ayant été déterminée préalablement, de façon à déterminer une estimation de déphasage initiale $\varphi_0$.

Puis pour chaque mot, le système effectue

- une première itération avec une correction de déphasage de $\varphi_0$ en 12. Il faut comprendre par itération, les étapes successives de correction de déphasage, en 12, de démappage souple, en 13, turbo décodage, en 14, calcul de la mesure M, en 15. Puis,
- une deuxième itération avec une correction de déphasage de $\varphi_1 = \varphi_0 - \Delta\varphi$ et
- une troisième itération avec $\varphi_2 = \varphi_0 + \Delta\varphi$.

Connaissant $\varphi_0, \varphi_1$ *et* $\varphi_2$ ainsi que M($\varphi_0$), M($\varphi_1$) et M($\varphi_2$) et par utilisation de l'équation (7), le système en déduit l'estimation $\varphi$ du déphasage, et lance alors la dernière itération pour ce mot afin d'obtenir le mot décodé en 16 avant de reboucler sur le mot suivant.

Il est remarquable de noter que durant les itérations de recherche et de calcul du déphasage, le turbo décodeur peut limiter le nombre d'itération interne qu'il effectue. En effet, les valeurs de fiabilité utilisées, et donc M(l), convergent très rapidement après quelques, de l'ordre de quatre, demi itérations.

Le dispositif ainsi décrit permet donc de façon aisée d'annuler le décalage de phase ou de le réduire suffisamment pour qu'il n'ait plus qu'une influence limitée sur la fiabilité des résultats du décodage.

Cependant pour certains types de codage source QAM, le dispositif ainsi décrit garde une ambiguïté de phase

à $\pi$ rd ou $\dfrac{\pi}{2}$ rd.

Ceci se présente quand l'étiquetage utilisé présente une symétrie à $\pi$ rd ou $\dfrac{\pi}{2}$ rd.

Par exemple, quand l'étiquetage, c'est-à-dire la représentation des symboles, utilisé est celui de la norme VDSL, figure 9, deux points symétriques par rapport au centre de la constellation se trouvent être dans ce cas étiquetés par deux séquences binaires complémentaires. Ainsi une rotation de $\pi$ a pour effet d'inverser tous les bits du mot de code. Or le complément d'un mot de code BCH étendu appartenant également à ce code, le résultat obtenu en sortie du dispositif est une valeur de fiabilité aussi importante que pour le mot original reçu sans rotation.

Sans mesure appropriée, cela peut avoir pour effet que, lors de l'initialisation du dispositif, quand ce dernier recherche le décalage initial, celui-ci se bloque en fait sur une valeur de décalage à $\pi$ près.

Une première solution consiste à choisir un étiquetage ne présentant pas ces symétries, comme, par exemple, l'étiquetage « Quasi-Gray ».

Mais cette solution n'est pas toujours possible car, par exemple, le type d'étiquetage est déjà choisi dans la norme.

En conséquence, la demanderesse propose une seconde solution qui a l'avantage d'être plus générale et plus performante.

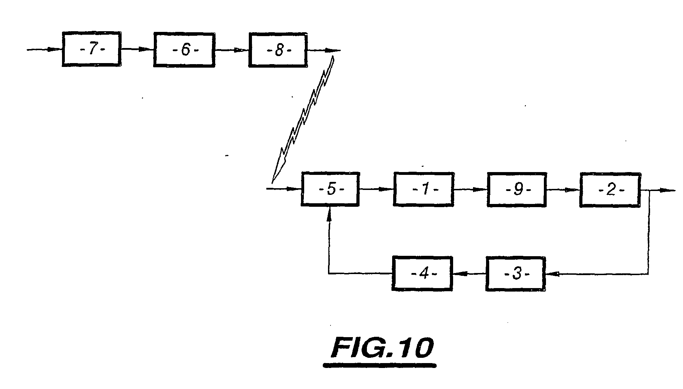

Cette seconde solution consiste, figure 10, à interposer un embrouilleur 6 de la taille d'un mot de code entre le codage canal 7 et l'opération de mapping 8 au niveau de l'émetteur. Une opération inverse de désembrouillage est alors réalisée au niveau du récepteur par interposition d'un désembrouilleur 9 entre le démappeur souple 1 et le turbodécodeur 2.

Cette seconde solution a de plus l'avantage d'atténuer fortement les extrema locaux présents en $-\dfrac{\pi}{2}$ et $\dfrac{\pi}{2}$, comme le montre la figure 9.

Le couple embrouilleur/désembrouilleur peut être remplacé par un couple entrelaceur/désentrelaceur ou tout autre système équivalent dont l'objet est de rompre la symétrie du codage canal.

Les résultats particulièrement avantageux du dispositif décrit sont validés par les expérimentations et simulations faites.

On obtient ainsi de manière particulièrement avantageuse, un dispositif de compensation de phase qui permet un turbo décodage dans des conditions optimales.

De plus, les opérations effectuées étant relativement simples, ce dispositif peut être construit de manière peu onéreuse en termes de puissance de calcul ou de taille de mémoire de travail.

**Revendications**

1. Système récepteur à turbo code d'un signal émis par un système émetteur, ce signal étant soumis par l'émetteur à un turbo codage et à une modulation numérique, **caractérisé en ce qu'**il comporte

- un démappeur souple (1) apte à recevoir le signal modulé et à le convertir en une suite de mots, chaque mots étant composés de n bits, et chaque bit étant connecté à une valeur de fiabilité de la valeur du bit, dont la sortie est connectée à

- un turbo décodeur (2) apte à générer une liste de mots correspondant aux données numériques décodées ainsi qu'un vecteur de fiabilité ($LLR_{out}$) du résultat associé à chaque mot et comportant la valeur de fiabilité de chaque bit du mot, ce turbo décodeur (2) étant un turbo décodeur à blocs comportant un décodeur SISO itératif

et comportant également une boucle d'asservissement adaptative comportant

- un générateur de mesure (3) dont l'entrée est connectée à la sortie du turbo décodeur afin de recevoir le vecteur de fiabilité ($LLR_{out}$) du résultat et apte à transformer ce vecteur en une mesure de fiabilité (M(I)), égale à la moyenne des plus petites valeurs de fiabilité des bits du mot, transmise à
- un estimateur (4) de déphasage apte à calculer l'écart entre la phase correspondant à la mesure de fiabilité (M(I)) reçue et celle correspondant au maximum de cette mesure, dont la sortie est connectée à
- un compensateur (5) de phase positionné en amont du démappeur souple et apte à corriger le signal entrant de la valeur de phase ($\varphi$) calculée par l'estimateur.

2. Système récepteur à turbo code selon la revendication 1, **caractérisé en ce que** le turbo décodeur (2) est tel que l'entrée ($R_m$) du décodeur SISO soit égale au vecteur (R) des valeurs de fiabilité en sortie du démappeur souple sommé par le produit d'un coefficient ($\alpha$) et de la différence entre la sortie ($R'_m$) du décodeur SISO à l'itération précédente et dudit vecteur (R) des valeurs de fiabilité en sortie du démappeur souple.

3. Système récepteur à turbo code selon la revendication 1 ou 2, **caractérisé en ce que** la mesure de fiabilité (M(I)) est égale à la moyenne des valeurs de fiabilité sensiblement inférieures à une valeur déterminée.

4. Système récepteur à turbo code selon l'une quelconque des revendications précédentes, **caractérisé en ce que** l'estimateur (4) de déphasage, estime le déphasage en supposant que la mesure de fiabilité (M(I)) est une fonction parabolique du déphasage

5. Système récepteur à turbo code selon la revendication 4, **caractérisé en ce que** l'estimateur (4) de déphasage, estime le déphasage comme la somme de l'estimation ($\varphi_0$) pour le mot de code précédent et d'une constante ($\Delta\varphi$) pondérée, un intervalle de calcul étant défini comme ayant pour centre l'estimation ($\varphi_0$) pour le mot de code précédent et pour demi largeur la constante ($\Delta\varphi$), et la pondération de la constante étant le ratio entre la différence entre les valeurs de fiabilité (M($\varphi_1$), M($\varphi_2$)) aux extrémités de l'intervalle de calcul et la quadruple valeur de fiabilité M($\varphi_0$) à l'estimation précédente diminuée du double de la somme des valeurs de fiabilité (M($\varphi_1$), M($\varphi_2$)) aux extrémités de l'intervalle de calcul.

6. Système récepteur à turbo code selon l'une quelconque des revendications précédentes, **caractérisé en ce que** la modulation est une modulation QAM.

7. Système récepteur à turbo code selon l'une quelconque des revendications précédentes, **caractérisé en ce qu'**un désembrouilleur (9) ou un désentrelaceur est intercalé entre le démappeur (1) souple et le turbo décodeur (2).

8. Système de transmission d'un flux de données numériques binaires, **caractérisé en ce qu'**il comporte un système récepteur selon l'une des revendications précédentes.

9. Système de transmission d'un flux de données numériques binaires selon la revendication 8, **caractérisé en ce qu'**un embrouilleur (6), ou un entrelaceur, est intercalé entre le codeur canal (7) et le modulateur (8) et qu'un désembrouilleur (9), respectivement un désentrelaceur, est intercalé entre le démappeur souple (1) et le turbodécodeur (2).

10. Procédé de réception d'un signal numérique turbo codé et modulé, **caractérisé en ce qu'**il comporte les étapes suivantes :

a) réception d'un élément de la constellation de la modulation,
b) démappage souple de cet élément pour obtenir un mot de n bits, chaque bit étant associé à une valeur de fiabilité de la valeur de ce bit,
c) turbo décodage de ce mot de n bits fournissant un autre mot correspondant aux données numériques décodées ainsi qu'un vecteur de fiabilité de ce résultat comportant la valeur de fiabilité de chaque bit du mot, ce turbo décodage étant un turbo décodage à blocs comportant un décodage SISO itératif tel que l'entrée du décodage SISO soit égale au vecteur des valeurs de fiabilité en sortie du démappage souple sommé par le produit d'un coefficient et de la différence entre la sortie du décodage SISO à l'itération précédente et dudit vecteur des valeurs de fiabilité en sortie du démappage souple.

d) calcul d'une mesure de fiabilité égale à la moyenne des plus petites valeurs de fiabilité des bits du mot,

e) estimation du déphasage par calcul de l'écart entre la phase correspondant à la mesure de fiabilité reçue et celle correspondant au maximum de cette mesure,

f) compensation par le déphasage estimé en réception du signal modulé.

**11.** Procédé de réception d'un signal numérique turbo codé et modulé selon la revendication 10, **caractérisé en ce qu'**à l'initialisation, l'estimation de déphasage parcourt l'espace des phases selon un pas égal à la moitié de la largeur du lobe de la mesure de fiabilité.

**12.** Procédé de réception d'un signal numérique turbo codé et modulé selon la revendication 10 ou 11, **caractérisé en ce que** pour chaque mot reçu, les étapes b) à f) sont itérées en utilisant comme estimation de déphasage,

- l'estimation de déphasage du mot précédent, puis
- l'estimation de déphasage du mot précédent moins une valeur prédéterminée, puis
- l'estimation de déphasage du mot précédent plus une valeur prédéterminée, puis,

l'estimation du déphasage ayant été calculée comme la somme de l'estimation ($\varphi_0$) pour le mot de code précédent et d'une constante ($\Delta\varphi$) pondérée, un intervalle de calcul étant défini comme ayant pour centre l'estimation ($\varphi_0$) pour le mot de code précédent et pour demi largeur la constante ($\Delta\varphi$), et la pondération de la constante étant le ratio entre la différence entre les valeurs de fiabilité ($M(\varphi_1)$, $M(\varphi_2)$) aux extrémités de l'intervalle de calcul et la quadruple valeur de fiabilité $M(\varphi_0)$ à l'estimation précédente diminuée du double de la somme des valeurs de fiabilité ($M(\varphi_1)$, $M(\varphi_2)$) aux extrémités de l'intervalle de calcul, les étapes b) et c) sont effectuées pour obtenir le mot correspondant aux données numériques décodées.

## Claims

**1.** Turbo-code receiver system for a signal emitted by an emitting system, this signal being subjected by the emitter to turbo-coding and digital modulation, **characterised in that** it comprises:

- a flexible demapper (1) adapted to receive the modulated signal and convert it into a series of words, each word being made up of n bits, and each bit being connected to a reliability value of the bit value, the output of which is connected to
- a turbo-decoder (2) adapted to generate a list of words corresponding to the digital data decoded as well as a reliability vector ($LLR_{out}$) of the result associated with each word and comprising the reliability value of each bit of the word, this turbo-decoder (2) being a block turbo-decoder comprising an iterative SISO decoder

and also comprising an adaptive servo loop comprising

- a measuring generator (3) the input of which is connected to the output of the turbo-decoder so as to receive the reliability vector ($LLR_{out}$) of the result and capable of transforming this vector into a reliability measurement (M(I)), equal to the mean of the smallest reliability values of the bits of the word, transmitted to
- a phase shift estimator (4) adapted to calculate the deviation between the phase corresponding to the reliability measurement (M(I)) received and the phase corresponding to the maximum of this measurement, the output of which is connected to
- a phase compensator (5) positioned upstream of the flexible demapper and adapted to correct the incoming signal of the phase value ($\varphi$) calculated by the estimator.

**2.** Turbo-code receiver system according to claim 1, **characterised in that** the turbo-decoder (2) is such that the input ($R_m$) of the SISO decoder is equal to the vector (R) of the reliability values at the output from the flexible demapper added to the product of a coefficient ($\alpha$) and the difference between the output ($R'_m$) from the SISO decoder on the previous iteration and the said vector (R) of the reliability values at the output from the flexible demapper.

**3.** Turbo-code receiver system according to claim 1 or 2, **characterised in that** the reliability measurement (M(I)) is equal to the mean of the reliability values substantially below a predetermined value.

4. Turbo-code receiver system according to any one of the preceding claims, **characterised in that** the phase shift estimator (4) estimates the phase shift by supposing that the reliability measurement (M(I)) is a parabolic function of the phase shift.

5. Turbo-code receiver system according to claim 4, **characterised in that** the phase shift estimator (4) estimates the phase shift as the sum of the estimate ($\varphi_0$) for the previous code word and a weighted constant ($\Delta\varphi$), a calculation interval being defined as having as its centre the estimate ($\varphi_0$) for the previous code word and having as its half-width the constant ($\Delta\varphi$), and the weighting of the constant being the ratio of the difference between the reliability values (M($\varphi_1$), M($\varphi_2$)) at the limits of the calculation interval and four times the reliability value (M($\varphi_0$) at the previous estimate, minus twice the sum of the reliability values (M($\varphi_1$), M($\varphi_2$)) at the limits of the calculation interval.

6. Turbo-code receiver system according to any one of the preceding claims, **characterised in that** the modulation is a QAM modulation.

7. Turbo-code receiver system according to any one of the preceding claims, **characterised in that** an unscrambler (9) or deinterlacer is interposed between the flexible demapper (1) and the turbo-decoder (2).

8. System for transmitting a flux of binary digital data, **characterised in that** it comprises a receiver system according to one of the preceding claims.

9. System for transmitting a flux of binary digital data according to claim 8, **characterised in that** a scrambler (6) or an interlacer is interposed between the channel coder (7) and the modulator (8) and **in that** an unscrambler (9) or a deinterlacer is interposed between the flexible demapper (1) and the turbo-decoder (2).

10. Method of receiving a turbo-coded and modulated digital signal, **characterised in that** it comprises the following steps:

a) receiving an element of the constellation of the modulation,
b) flexible demapping of this element to obtain a word of n bits, each bit being associated with a reliability value of the value of this bit,
c) turbo-decoding of this n-bit word, supplying another word corresponding to the digital data decoded and a reliability vector of this result comprising the reliability value of each bit of the word, this turbo-decoding being a block turbo-decoding comprising an iterative SISO decoding such that the input of the SISO decoding is equal to the vector of the reliability values at the output from the flexible demapping added to the product of a coefficient and the difference between the output of the SISO decoding on the previous iteration and said vector of the reliability values at the output from the flexible demapping,
d) calculating a measurement of reliability equal to the mean of the smallest reliability values of the bits of the word,
e) estimating the phase shift by calculating the deviation between the phase corresponding to the reliability measurement received and that corresponding to the maximum of this measurement,
f) compensating by the phase shift estimated on receiving the modulated signal.

11. Method of receiving a turbo-coded and modulated digital signal according to claim 10, **characterised in that** on initialisation the phase-shift estimate runs through the phase space at a rate equal to half the lobe width of the reliability measurement.

12. Method of receiving a turbo-coded and modulated digital signal according to claim 10 or 11, **characterised in that** for each word received, steps b) to f) are iterated using, as phase-shift estimate,

- the phase-shift estimate of the previous word, then
- the phase-shift estimate of the previous word minus a predetermined value, then
- the phase-shift estimate of the previous word plus a predetermined value, then,

once the phase-shift estimate has been calculated as the sum of the estimate ($\varphi_0$) for the previous code word and a weighted constant ($\Delta\varphi$), a calculation interval being defined as having for its centre the estimate ($\varphi_0$) for the previous code word and having as its half-width the constant ($\Delta\varphi$), and the weighting of the constant being the ratio of the difference between the reliability values (M($\varphi_1$), M($\varphi_2$)) at the limits of the calculation interval and four times the reliability value (M(φ) at the previous estimate, minus twice the sum of the reliability values (M(φ$_1$), M(φ$_2$)) at the limits of the calculation interval, steps b) and c) are carried out in order to obtain the word corresponding to the decoded digital data.

**Patentansprüche**

1. Turbocode-Empfangssystem eines von einem Sendesystem gesendeten Signals, wobei dieses Signal vom Sender einer Turbocodierung und einer digitalen Modulation unterzogen wird, **dadurch gekennzeichnet, dass** es aufweist:

   - einen Soft-Demapper (1), der in der Lage ist, das modulierte Signal zu empfangen und es in eine Folge von Wörtern umzuwandeln, wobei jedes Wort aus n Bits zusammengesetzt ist, und jedes Bit mit einem Zuverlässigkeitswert des Bitwerts verbunden ist, dessen Ausgang verbunden ist mit
   - einem Turbodecodierer (2), der in der Lage ist, eine Liste von Wörtern, die den decodierten digitalen Daten entsprechen, sowie einen Zuverlässigkeitsvektor (LLR$_{out}$) des Ergebnisses zu erzeugen, das jedem Wort zugeordnet ist und den Zuverlässigkeitswert jedes Bits des Worts enthält, wobei dieser Turbodecodierer (2) ein Turbodecodierer mit Blöcken ist, der einen iterativen SISO-Decodierer aufweist

   und ebenfalls eine adaptive Regelschleife aufweist, die aufweist:

   - einen Messgenerator (3), dessen Eingang mit dem Ausgang des Turbodecodierers verbunden ist, um den Zuverlässigkeitsvektor (LLR$_{out}$) des Ergebnisses zu empfangen, und der in der Lage ist, diesen Vektor in ein Zuverlässigkeitsmaß (M(I)) umzuwandeln, das gleich dem Mittelwert der kleinsten Zuverlässigkeitswerte der Bits des Worts ist, übertragen an
   - einen Phasenverschiebungsschätzer (4), der in der Lage ist, den Abstand zwischen der dem empfangenen Zuverlässigkeitsmaß (M(I)) entsprechenden Phase und derjenigen zu berechnen, die dem Maximum dieses Maßes entspricht, dessen Ausgang verbunden ist mit
   - einem Phasenkompensator (5), der vor dem Soft-Demapper angeordnet und in der Lage ist, das eingehende Signal des vom Schätzer berechneten Phasenwerts (φ) zu korrigieren.

2. Turbocode-Empfangssystem nach Anspruch 1, **dadurch gekennzeichnet, dass** der Turbodecodierer (2) derart ist, dass der Eingang (R$_m$) des SISO-Decodierers gleich dem Vektor (R) der Zuverlässigkeitswerte am Ausgang des Soft-Demappers summiert mit dem Produkt aus einem Koeffizienten (α) und der Differenz zwischen dem Ausgang (R'$_m$) des SISO-Decodierers bei der vorhergehenden Iteration und dem Vektor (R) der Zuverlässigkeitswerte am Ausgang des Soft-Demappers ist.

3. Turbocode-Empfangssystem nach Anspruch 1 oder 2, **dadurch gekennzeichnet, dass** das Zuverlässigkeitsmaß (M(I)) gleich dem Mittelwert der Zuverlässigkeitswerte ist, die deutlich unter einem bestimmten Wert liegen.

4. Turbocode-Empfangssystem nach einem der vorhergehenden Ansprüche, **dadurch gekennzeichnet, dass** der Phasenverschiebungsschätzer (4) die Phasenverschiebung schätzt, indem er annimmt, dass das Zuverlässigkeitsmaß (M(I)) eine parabolische Funktion der Phasenverschiebung ist.

5. Turbocode-Empfangssystem nach Anspruch 4, **dadurch gekennzeichnet, dass** der Phasenverschiebungsschätzer (4) die Phasenverschiebung als die Summe der Schätzung (φ$_0$) für das vorhergehende Codewort und einer gewichteten Konstanten (Δφ) schätzt, wobei ein Rechenintervall so definiert wird, dass es als Zentrum die Schätzung (φ$_0$) für das vorhergehende Codewort und als Halbbreite die Konstante (Δφ) hat, und die Gewichtung der Konstanten das Verhältnis zwischen der Differenz zwischen den Zuverlässigkeitswerten (M(φ$_1$), M(φ$_2$) ) an den Enden des Rechenintervalls und dem vierfachen Zuverlässigkeitswert (M(φ$_0$)) bei der vorhergehenden Schätzung, verringert um das Doppelte der Summe der Zuverlässigkeitswerte (M(φ$_1$), M(φ$_2$) ) an den Enden des Rechenintervalls ist.

6. Turbocode-Empfangssystem nach einem der vorhergehenden Ansprüche, **dadurch gekennzeichnet, dass** die Modulation eine QAM-Modulation ist.

7. Turbocode-Empfangssystem nach einem der vorhergehenden Ansprüche, **dadurch gekennzeichnet, dass** ein Descrambler (9) oder ein Deinterlacer zwischen den Soft-Demapper (1) und den Turbodecodierer (2) eingefügt ist.

8. System zur Übertragung eines Stroms von digitalen Binärdaten, **dadurch gekennzeichnet, dass** es ein Empfangssystem nach einem der vorhergehenden Ansprüche aufweist.

9. System zur Übertragung eines Stroms von digitalen Binärdaten nach Anspruch 8, **dadurch gekennzeichnet, dass** ein Scrambler (6) oder ein Interlacer zwischen den Kanalcodierer (7) und den_Modulator (8) eingefügt ist und dass ein Descrambler (9) bzw. ein Deinterlacer zwischen den Soft-Demapper (1) und den Turbodecodierer (2) eingefügt ist.

10. Verfahren für den Empfang eines turbocodierten und modulierten digitalen Signals, **dadurch gekennzeichnet, dass** es die folgenden Schritte aufweist:

   a) Empfang eines Elements der Konstellation der Modulation,
   b) Soft-Demapping dieses Elements, um ein Wort mit n Bits zu erhalten, wobei jedes Bit einem Zuverlässigkeitswert des Werts dieses Bits zugeordnet ist,
   c) Turbodecodierung dieses Worts von n Bits, die ein anderes Wort, das den decodierten digitalen Daten entspricht, sowie einen Zuverlässigkeitsvektor dieses Ergebnisses liefert, der den Zuverlässigkeitswert jedes Bits des Worts enthält, wobei diese Turbodecodierung eine Turbodecodierung mit Blöcken ist, die eine derartige iterative SISO-Decodierung aufweist, dass der Eingang der SISO-Decodierung gleich dem Vektor der Zuverlässigkeitswerte am Ausgang des Soft-Demapping, summiert mit dem Produkt aus einem Koeffizienten und der Differenz zwischen dem Ausgang der SISO-Decodierung bei der vorhergehenden Iteration und dem Vektor der Zuverlässigkeitswerte am Ausgang des Soft-Demapping ist,
   d) Berechnung eines Zuverlässigkeitsmaßes gleich dem Mittelwert der kleinsten Zuverlässigkeitswerte der Bits des Worts,
   e) Schätzung der Phasenverschiebung durch Berechnung des Abstands zwischen der dem empfangenen Zuverlässigkeitsmaß entsprechenden Phase und derjenigen, die dem Maximum dieses Maßes entspricht,
   f) Kompensation durch die geschätzte Phasenverschiebung beim Empfang des modulierten Signals.

11. Verfahren für den Empfang eines turbocodierten und modulierten digitalen Signals nach Anspruch 10, **dadurch gekennzeichnet, dass** bei der Initialisierung die Phasenverschiebungsschätzung den Raum der Phasen gemäß einem Gang gleich der Hälfte der Breite der Keule des Zuverlässigkeitsmaßes durchläuft.

12. Verfahren für den Empfang eines turbocodierten und modulierten digitalen Signals nach Anspruch 10 oder 11, **dadurch gekennzeichnet, dass** für jedes empfangene Wort die Schritte b) bis f) wiederholt werden, indem als Phasenverschiebungsschätzung verwendet wird

   - die Schätzung der Phasenverschiebung des vorhergehenden Worts, dann
   - die Schätzung der Phasenverschiebung des vorhergehenden Worts minus einen vorherbestimmten Wert, dann
   - die Schätzung der Phasenverschiebung des vorhergehenden Worts plus einem vorbestimmten Wert, dann,

da die Schätzung der Phasenverschiebung als Summe der Schätzung ($\varphi_0$) für das vorhergehende Codewort und einer gewichteten Konstanten ($\Delta\varphi$) berechnet wurde, da ein Rechenintervall so definiert wird, dass es als Zentrum die Schätzung ($\varphi_0$) für das vorhergehende Codewort und als Halbbreite die Konstante ($\Delta\varphi$) hat, und da die Gewichtung der Konstanten das Verhältnis zwischen der Differenz zwischen den Zuverlässigkeitswerten ($M(\varphi_1)$, $M(\varphi_2)$) an den Enden des Rechenintervalls und dem vierfachen Zuverlässigkeitswert $M(\varphi_0)$ bei der vorhergehenden Schätzung, verringert um das Doppelte der Summe der Zuverlässigkeitswerte ($M(\varphi_1)$, $M(\varphi_2)$) an den Enden des Rechenintervalls ist, die Schritte b) und c) durchgeführt werden, um das den decodierten digitalen Daten entsprechende Wort zu erhalten.

## FIG.1

*(art antérieur)*

## FIG.2

**_FIG.3_**

**_FIG.4_**

(art antérieur)

**_FIG.5_**

BCH(32,26,4)¹ sur 1024 QAM avec Eb/No = 21 dB

**FIG.6**

**FIG.7**

**_FIG.8_**

**_FIG.9_**

**FIG.10**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0654910 A

- US 20020097814 A, Eidson

**Littérature non-brevet citée dans la description**

- **WANGROK OH ; KYUNGWHOON CHEUN.** Joint Decoding and Carrier Phase Recovery Algorithm for Turbo Codes. *IEEE Communications Letters,* Septembre 2001, vol. 5 (9), 375

- **LOTTICI F ; LUISE M.** Embedding Carrier Phase Recovery Into Iterative Decoding of Turbo-Coded Linear Modulations. *IEEE transactions on communications,* Avril 2004, vol. 52 (4), 661-669